# EUROPEAN PATENT APPLICATION

(11) **EP 2 246 904 A1**
(43) Date of publication of application: **03.11.2010**
(21) Application number: 08871933.1
(22) Date of filing: 05.12.2008
(51) Int. Cl.: H01L 31/052, F24J 2/40

(54) **LOW CONCENTRATION SOLAR PLANT AND METHOD FOR MAXIMIZING THE ELECTRICITY PRODUCTION OF THE PHOTOVOLTAIC MODULES THEREOF**

(30) Priority: 30.01.2008 ES 200800242
(71) Applicant: Abengoa Solar New Technologies, S.A., 41018 Sevilla (ES)
(72) Inventor: ENRILE MEDINA, Juan, E-41018 Sevilla (ES); OSUNA GONZALEZ-AGUILAR, Rafael, E-41018 Sevilla (ES); FERNANDEZ QUERO, Valerio, E-41018 Sevilla (ES); PERELES LIGERO, Oscar, E-41018 Sevilla (ES); PAYAN RODRIGUEZ, Alvaro, E-41018 Sevilla (ES)
(74) Representative: Garcia-Cabrerizo y del Santo, Pedro Maria
(86) International application number: PCT/ES2008/000763
(87) International publication number: WO 2009/095509

(57) **Abstract**

Low concentration solar plant and method for maximizing the electricity production of the photovoltaic modules thereof, that uses a combination of tracking and low concentration solar technologies for maximizing the electricity production of conventional photovoltaic modules, the system used to protect the modules being any method designed to protect photovoltaic modules from the damage they may suffer when subjected to very high intensity solar radiation. Preferably, to avoid possible damage, the invention proposes a temperature measurement and/or control system that assists a mechanism for defocusing the photovoltaic modules when said radiation reaches a predetermined level. The invention is applicable to photovoltaic solar electricity production.

## Description

### OBJECT AND FIELD OF THE INVENTION:

The invention that is described and claimed bellow is based on the combined use of solar low concentration systems and tracking systems according to two axes. The final objective being pursued is to maximize the electricity produced by photovoltaic modules, thus achieving by this combined method a more competitive cost of the generated electricity.

### BACKGROUND OF THE INVENTION:

The energetic demand rapidly grows and the fossil fuel prices does also; additionally, this situation does not seem reversible, on the contrary it will be worst, since the reserves of such fuels are more and more scarce. Is in this setting where is the great opportunity for renewable energies as clean and inexhaustible energy source.

From five years ago, the photovoltaic energy production industry has grown with a rate close to 40%. This growth, particularly suggestive, has attracted very different industrial sectors, which have been decisively dedicated to explore business possibilities that this interesting technological field may offer.

In 2006 this spectacular growth continued, providing the market around 2,400 MW. According to the analysts, this growth will continue in the coming years, wherewith the sector of the photovoltaic energy could count on a production capacity of 10 GW in 2010 (which would suppose business numbers around 72 billions of dollars).

Data from 2005 proved that the world photovoltaic market grew in that year more than 45%, reaching a production of 1,759 MW. In 2006, the estimations located this number in 2,400 MW, which indicates that the sector follows its spectacular growth rate.

In 2005, as in previous years, the market with the most growth was the German, with 603 MW, followed by the Japanese, with 291 MW, and by the American, with 108 MW. In this regard, Spain was ranked as the second European country, after Germany, in photovoltaic facilities.

As regards manufacture of photovoltaic cells and modules, Europe experienced a growth of 50%, reaching a production of 470 MW. However, and despite this fact, the great growth of the German market has meant that Europe remains as a net importer of cells and modules. Nevertheless, this situation may change in a close future.

One of the major problems that has limited the sector in recent years has been the shortage of silicon, and consequently the cost increase of wafers of this material. This has led the cell and module manufacturer companies to sign very long-term contracts. In this way, module manufacturers seek to secure the supply ahead to the coming years.

Likewise, as a consequence of this shortage of silicon, cell manufacture companies based on the use of thin sheets, and others that have developed solar concentration product have appeared, being introduced little by little in the market, and making the companies that had traditionally worked with technologies based on silicon to diversify their developments.

The current situation for marketing photovoltaic concentrators is developed behind hopes and expectations. There are a large number of different technologies attempting to obtain suitable technical and economical solutions. I+D programs, for photovoltaic concentrators, have been carried out for decades. In the seventies and eighties, several photovoltaic concentration systems had already been developed. These developments have continued until now with improved cells, with high concentration ratios, using to such interesting effect a great variety of technical solutions.

From the pioneering studies of Hollands and Stacey, a number of studies on photovoltaic systems operated with V-Through concentrators has been published, being of special relevance that made by Fraindenralch. However, none of these has still reached significant marketing levels or the increase in more than 100% of the annual electrical production, such as it is set forth in the present invention, this in part motivated, by the risk that supposes the temperature increase in a conventional silicon cell.

### DESCRIPTION OF THE INVENTION

Photovoltaic devices are based on the electricity production from the solar resource. This is variable and depends on multiple parameters, such as the geographical location, the day and time, the atmospheric conditions, etc. The energetic production of the photovoltaic modules depends directly on the characteristics of this resource, but also depends on the way of use it.

In order to maximize the annual electricity production of photovoltaic modules it will be necessary to maximize the solar radiation amount received at any time.

For this, in the present invention, the followed measures have been adopted:
a) Adjacent mirrors have been added to increase the solar radiation received by photovoltaic modules, which allows increasing even more the annual energetic production. The concentration technology that has been used is the V-Through technology, allowing geometric concentration between 1 and 3x (x being defined as the equivalent number of suns receiving the photovoltaic modules. That is, by supposing that a conventional flat module exposed to solar radiation receives one sun, a concentration of 3x is equivalent to say that the module receives a solar radiation 3 times higher or equivalent to 3 suns). This involves a production increase of conventional modules of more than 50%.
b) The photovoltaic modules have been provided with a solar tracking system according to two axes. Thus, the annually produced energy can be increased up to 42% in terms of the geographical location.
   By bounding both improvements it is possible to increase the annually produced electricity in more than 100%.
c) The photovoltaic modules have been provided, to prevent from the damage they may suffer due to an excessive temperature increase at the time of maximum solar radiation, with a temperature sensor, that acts on the tracking system, taking this to a "non solar tracking or defocusing" position, in case of reaching certain predetermined high temperature.

The V-Through solar concentration technology has been widely used in recent years. However, until now its use in combination with the solar tracking according to two axes had not been set forth, mainly for two reasons:
1. Given the acceptance angles that are obtained with this technology, carrying out a tracking of the solar path does not result indispensable. A simple fixed facility, properly orientated, results sufficient to improve the energetic production against a conventional flat module.
2. Although the solar tracking significantly increases the received radiation, and therefore the electrical production, its use in combination with V-Through solar concentration techniques can cause a devastating effect on a conventional silicon cell due to the large temperature increase to which would be subjected, since the cells can not reach excessively high temperatures, as they might be burnt and be totally useless.
At this point results necessary to outline the high grade of importance that the temperature defocusing system reaches in this approach. No one could speak of V-Through technology, with tracking according to two axes, using conventional silicon modules, without a defocusing system that protects the module against extreme temperature rises.

The photovoltaic concentration consists of replacing part of the solar cells (most costly element of the photovoltaic systems) by optical systems (so-called concentrators), that direct the light over the cells with a lower size. Photovoltaic concentration systems make use, for this purpose, of an optical element, such a lens or mirror, for focusing the solar light over a photovoltaic material of lower size.

In order to characterize the concentration grade to which the work is done, a parameter called geometric concentration is used. Namely, said parameter is defined as the existing relation between the area wherein the solar radiation incides and the area of the respective cell.

The final objective being pursued by the solar concentration techniques is the cost reduction of the photovoltaic energy. To such effect, it has to be considered that the optical element that is added, to the conventional photovoltaic solution, must not get over the cost of the cell area that it replaces.

The conventional photovoltaic modules are exposed to the solar radiation that naturally reaches their surfaces. Generally, the radiation that the module receives can be increased by placing the modules with a tilting toward the sun equal to the latitude of the location. If one wishes to maximize the radiation incident on the module a facility with tracking can be used. Said facility uses a solar tracker, which allows tracking the solar path along the day, and conveniently orientates the module, thus increasing the solar energy amount that incides thereon.

In function of the concentration grade wherewith the work is done and the used optical system, the solar tracking can result indispensable. Specially, on systems of high photovoltaic concentration (geometric concentration > 100x), wherein the acceptance angles that are arranged are so low that are only achieved using a solar tracking according to two axes. Contrarily, for systems of low concentration, said tracking is not usually necessary.

The main benefit of using photovoltaic concentration is the efficient use of the material constituting the solar cells. For a given electrical production, the concentration systems use a much lower amount of semiconductor material than the systems that use flat modules. The great areas of mirrors or lenses, compared with the great areas of semiconductor material, lead to low cost systems. The manufacturing processes of the concentrator elements are less complex than those for manufacturing solar cells, and can be easily escalated, which gives a great advantage to the concentration technology.

The requested investment for a production plant of 100 MWh/year, based on concentration technology, can be placed, once having a sufficiently mature technology, around 50-60% bellow the investment required by the technology based on the use of crystalline silicon in thin wafers or films. The annual cost, for photovoltaic systems based on flat modules, per W of installed power, is comprised between 5 and 6 $/W, whereas with solar concentration technologies costs around 3 $/W, can be reached in short term.

By the three improvement introduced in the present invention, an increment in more than 100% of the annual production is achieved, without excessively increasing the total cost of the system and backing up the lifetime thereof. Thus a significant reduction of the final cost of the produced energy is produced.

### DESCRIPTION OF THE DRAWINGS

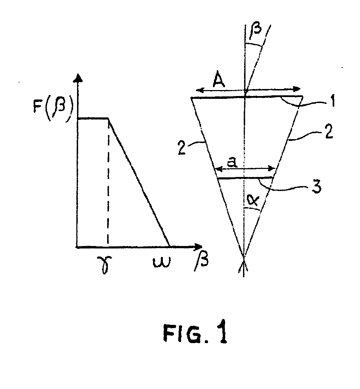

In figure 1, the basic geometry of a type V cavity, and the general form of the angular acceptance function are reflected.

Therein, the references have the following meaning:
1.- Solar aperture area.
2.- Reflective mirrors.
3.- Flat and conventional photovoltaic panel.

### DETAILED DESCRIPTION OF A PREFERRED EMBODIMENT:

Next, a preferred application of the invention without supposing that the invention patent that is applied, is restricted to the application detailed here and now, referring to a plant based on V-Through technology, in photovoltaic modules, and solar tracking according to two axes, is described in detail.

The V-Through concentrators used with their aperture area (1) as shown in Figure 1 wherein the basic geometry of a type V cavity is shown, basically comprise a flat and conventional photovoltaic module (3), and two additional reluctant surfaces or reflective mirrors (2), located at both sides and tilted in a defined angle. The major objective is to reduce the energy production cost (€/kWh) by reducing the area of the semiconductors, using for this purpose reflective mirrors to maximize the captured energy that comes through the aperture area (1) of the concentrators.

Due to the use of flat photovoltaic modules, and with the objective of preventing the installation of additional cooling systems, the required conditions of the basic design are:
- smooth lighting in the receiver, in order to reduce the losses due to mismatch;
- unique reflection of the direct light of the sun on the mirror before reaching the receiver, in order to thus maximize the losses due to reflection; and
- concentration ratios around 2x, for efficiency and reliability reasons, with the object of maximizing the generated energy, by maintaining the temperature of the photovoltaic modules at not destructive levels, and without a notable reduction of the generated power (energetic efficiency).

The concentration technique, so-called V-Through, is based on reflecting part of the solar radiation that does not directly reach the surface of the photovoltaic module over it using mirrors conventionally located. Thus the panel receives the solar radiation coming directly from the sun and, additionally, that reflected by the mirrors. As the cost of the surface unit of the mirrors is at least 30 times less than that of the photovoltaic modules, a notorious reduction of the investment cost for a plant that uses this technology can be obtained.

The systems for tracking the sun according to two axes (solar Trackers) provide an increase in the value of the annually produced energy which can raging between 35 and 50%, for European latitudes, on the value of the energy produced by static photovoltaic systems. Particularly, for concentration systems, the solar tracking is necessary, since the direct radiation is the most representative in the energetic production of this type of systems.

The cost attributed to the solar tracking systems is very higher than that associated to the systems that use fixed structures. However, for high efficient photovoltaic generators, the use of solar tracking systems is properly justified by the annual increase of produced energy.

The pant here described bases it technical feasibility in the following numbers:
1.- Annual energy increase with regard to flat modules between 60 and 90%.
2.- Annual energy increase with regard to fixed modules between 35 and 50%.
3.-Annual energy increase between 81 and 135% with regard to fixed flat systems of the conventional type

Thus, the generation cost of the energy unit is only 50% of the conventional generation cost with flat photovoltaic modules.

Since photovoltaic modules show a high sensitivity against extreme temperatures, it is included in the plant defined in the present invention, a protection systems that allows reducing the module temperature when certain levels that may damage the module itself are reached.

The system for defocusing the solar tracker by increasing the temperature measures the cell temperature according to which it follows a certain path for reaching the solar defocusing. The temperature measurement should be directly made on the surface of the photovoltaic module. The ambient temperature is not a valid data, since that reached by the cell will depend on others parameters, as can be the wind speed or the heat absorption properties of the photovoltaic cell itself. Likewise, the path that the solar tracker should follow up to reach a protection position (solar defocusing) should allow preventing non-homogeneous reflections on the photovoltaic panel that may cause its degradation. The correct definition of said path will significantly influence in the module degradation and, consequently, in the lifetime of the system.

The solar tracker is thus provided with a system for monitoring the photovoltaic module temperature. In case that the result of said monitoring gets over certain predetermined threshold, the system should automatically be capable of performing a defocusing movement, following a certain path preventing non-homogeneous reflections on the photovoltaic module.

It is not considered necessary to make this description more extensive for any skilled in the art understands the scope of the present invention, such as the technical effects and the new benefits that can be derived from thereof.

The terms in which the present technical specification has been written will have to be always taken into the widest and less limitative sense resulting compatible with the essence of the invention that is described and claimed therein.

## Claims

1. Low concentration solar plant and method for maximizing the electricity production of the photovoltaic modules thereof, which is **characterized in that** it uses a combination of tracking and low concentration solar technologies for maximizing the electricity production of conventional photovoltaic modules, using, as a system for protecting the modules, any system designed to protect photovoltaic modules from the damage they may suffer when storing extreme temperatures.

2. Low concentration solar plant and method for maximizing the electricity production of the photovoltaic modules thereof according to claim 1, which is **characterized in that** the system for protecting photovoltaic modules, consists in a system for defocusing the solar tracker determining the path that the solar tracker should follow until reach a protection position (solar defocusing).

3. Low concentration solar plant and method for maximizing the electricity production of the photovoltaic modules thereof according to claim 1, which is **characterized in that** the solar tracker is provided with a system for monitoring the temperature of the photovoltaic module.

4. Low concentration solar plant and method for maximizing the electricity production of the photovoltaic modules thereof according to claim 2, which is **characterized in that** the system for defocusing the solar tracker is actuated from a system for measuring and/or controlling the temperature of the photovoltaic module, from the moment when the photovoltaic module gets over a threshold that might irreversible damage the photovoltaic modules.

5. Low concentration solar plant and method for maximizing the electricity production of the photovoltaic modules thereof according to claims 3 and 4, which is **characterized in that** the temperature measurement is performed directly on the surface of the photovoltaic module.

## Amended claims

### Amended claims under Art. 19.1 PCT

1. Low concentration solar plant for maximizing the electricity production of the photovoltaic modules thereof **characterized by** the combined use of three elements: adjacent mirrors in the solar concentrator, solar tracker in two axes and system for protecting the photovoltaic modules from the damage they may suffer when storing extreme temperatures.

2. Low concentration solar plant for maximizing the electricity production of the photovoltaic modules thereof according to claim 1 **characterized in that** the system for protecting the photovoltaic modules consists of a system for defocusing the solar tracker having an element for monitoring the temperature which performs the measurements directly on the surface of the photovoltaic module.

3. Method for maximizing the electricity production of the photovoltaic modules of a low concentration solar plant as that described in the preceding claims **characterized in that** the system for protecting the photovoltaic modules carries out the following operations:
- measuring the temperature on the surface of the photovoltaic module,
- monitoring and controlling said temperatures,
- actuating the defocusing system if a predetermined threshold temperature that might irreversible damage the photovoltaic modules is reached.
- calculating on the part of the defocusing system the path that the solar tracker should follow so as to prevent non-homogeneous reflections over the photovoltaic module, and
- placing the module in a protection position.
